# EUROPÄISCHE PATENTSCHRIFT

(11) **EP 0 351 559 B1**
(45) Veröffentlichungstag und Bekanntmachung des Hinweises auf die Patenterteilung: **01.12.1993**
(21) Anmeldenummer: 89111016.5
(22) Anmeldetag: 16.06.1989
(51) Int. Cl.: G01R 31/02, G01R 31/08

(54) **Einrichtung zum Erfassen von inneren Fehlern bei einer Hochspannungskondensatorbatterie**
Device for the detection of internal faults in a high-voltage capacitor battery
Dispositif pour la détection de fautes internes d'une batterie de condensateurs à haute tension

(30) Priorität: 29.06.1988 DE 3821944
(43) Veröffentlichungstag der Anmeldung: 24.01.1990
(73) Patentinhaber: SIEMENS AKTIENGESELLSCHAFT, 80333 München (DE)
(72) Erfinder: Becker, Michael, Dipl.-Ing., D-8525 Uttenreuth (DE); Renz, Klaus, Dipl.-Ing., D-8525 Uttenreuth (DE)

(56) Entgegenhaltungen:
- EP-A- 0 187 312
- DE-A- 1 763 861
- DE-A- 2 903 319
- DE-A- 2 930 034
- DE-B- 2 807 095
- US-A- 4 219 856

## Beschreibung

Die Erfindung bezieht sich auf ein Verfahren und eine Einrichtung zur Erfassung eines inneren Fehlers und gleichzeitiger Zuordnung dieses Fehlers zum jeweils fehlerbehafteten Kondensatorbaustein einer aus zumindest zwei parallelen Zweigen mit jeweils mindestens drei in Reihe geschalteten Kondensatorbausteinen bestehenden Hochspannungskondensatorbatterie.

Aus verschiedenen Gründen nimmt der Einsatz von Hochspannungskondensatoren mit innenliegenden Wickelsicherungen zu. Da keine Anzeige der Fehlerbausteine durch sichtbar abgetrennte Sicherungen möglich ist, wird es immer wichtiger, den Fehlerzustand der Kondensatorbänke durch elektrische Messungen zu erfassen. Die bisher auf dem Markt befindlichen Geräte befriedigen nicht. Insbesondere ist es sehr zeitaufwendig, die gesamten Kondensatoren durchzumessen, um eventuelle Fehler erkennen zu können.

Aus der Entgegenhaltung US-PS 4 219 856 ist eine Kondensatorbatterie mit vier Teilbatterien bekannt, welche paarweise in Reihe geschaltet und in zwei parallelen Zweigen angeordnet sind. Die parallelen Zweige enthalten jeweils Längsimpedanzen. An Punkten gleichen Potentials zwischen den Längsimpedanzen sind zwei Querstromwandler mit Mittelanzapfung geschaltet, welche über einen dritten Wandler miteinander verbunden sind. Die Sekundärseiten der Wandler sind an eine Erfassungseinrichtung, welche eine Spannungsüberwachungseinrichtung umfaßt und eine Fehlerzuordnung zu einer Teilbatterie erlaubt, angeschlossen. Ungünstig ist bei dieser Ausführung, daß zusätzlich zu den Wandlern Induktivitäten mit spannungsbegrenzenden Elementen in der Kondensatorbatterie vorgesehen sind.

Die Aufgabe der vorliegenden Erfindung besteht darin, ein Verfahren und eine einfache Einrichtung zu schaffen, durch die ein Fehler eingegrenzt werden kann, und damit den Meßumfang auf ein Viertel oder ein Achtel des bisherigen Wertes zu verringern.

Diese Aufgabe wird bezüglich des Verfahrens gemäß Anspruch 1 und bezüglich der Vorrichtung gemäß Anspruch 2 gelöst.

Eine erfindungsgemäße Vorrichtung zur Durchführung des Verfahrens bei Kondensatorbausteinen, die mindestens paarweise in Reihe geschaltet und zumindest in zwei parallelen Zweigen angeordnet sind, besteht aus mindestens einem Querstromwandler und einer aus mindestens zwei Vorzeichenbausteinen mit nachgeschalteter Auswähllogik bestehenden Auswerteschaltung, wobei jeweils dem Vorzeichenbaustein ein ermittelter Querstrom und der ermittelte Gesamtstrom zugeführt sind.

Eine weitere Verbesserung, insbesondere in wirtschaftlicher Hinsicht, ergibt sich durch eine derartige Aufteilung der Kondensatorbatterie, daß benachbarte Querzweige ein elektrisches Potential haben, das einen einzigen Wandler mit verschiedenen Sekundärwicklungen zuläßt.

Nimmt man an, daß die Kondensatorbatterie in sechs gleiche Teile in Form einer Doppel-H-Brückenschaltung unterteilt ist und ein Fehler nur in einer Teilbatterie aufgetreten wäre, würde sich das Durchmessen zur bisherigen Fehlersuche in einem Sechstel der Zeit durchführen lassen. Durch die Aufteilung der Batterie wird außerdem die Meßempfindlichkeit linear erhöht. Das die Querströme und deren Phasenlagen auswertende Gerät muß so empfindlich sein, daß jede einzelne Wickelabtrennung erfaßbar ist. Hierzu wird die stationäre Änderung der Kapazität benutzt, die mittels der Grundschwingung des Stromes meßbar ist. In Weiterbildung der Erfindung kann es weiterhin noch vorteilhaft sein, wenn man die Einzelvorgänge je Teilbatterie zählt, um statistische Aussagen zu erhalten.

Anhand eines in der Zeichnung dargestellten Ausführungsbeispiels sei die Erfindung näher erläutert; es zeigen:
- FIG 1: das Prinzipschaltbild eines Kondensatorbausteins,
- FIG 2: eine Aufteilung einer Kondensatorbatterie in eine Doppel-H-Brückenschaltung,
- FIG 3: eine Wahrheitstabelle hinsichtlich der Phasenlage von Querstrom zu Gesamtstrom,
- FIG 4: eine abgewandelte Anordnung mit Querstromzweigen von nahezu gleichem elektrischen Potential,
- FIG 5: eine Schaltungsanordnung zur Auswertung der Signale in der Schaltung nach FIG 2 und
- FIG 6: den detaillierten Aufbau eines Bausteins zur Erfassung der Phasenlage von Querstrom zu Gesamtstrom.

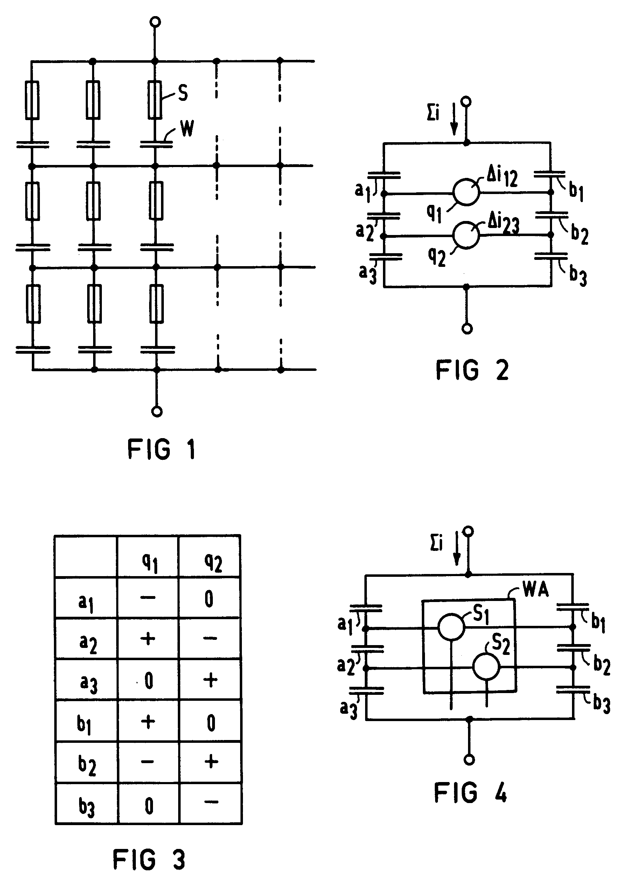

Wie aus FIG 1 ersichtlich, besteht jeder Kondensatorbaustein aus ein Vielzahl von parallel und in Reihe geschalteten Einzelwicklungen W, denen jeweils eine Schmelzsicherung S zugeordnet ist.

Die in FIG 2 dargestellte Gesamtkondensatorbatterie ist in sechs Teile a₁, a₂, a₃ bzw. b₁, b₂, b₃ aufgeteilt. Jedes dieser Teile besteht wieder aus einer Vielzahl von in Reihe und parallelgeschalteten Bausteinen nach FIG 1. Es soll nun die Aufgabe gelöst werden zu bestimmen, in welchem Teil der in Doppel-H-Schaltung ausgeführten Kondensatorbatterie ein Fehler aufgetreten ist. Hierzu werden die Querströme Δ i₁₂ und Δ i₂₃ zwischen den Parallelzweigen mittels Querstromwandlern q1 und q2 erfaßt und in ihrer Phasenlage mit der Gesamtstromsumme Σi verglichen. Liegt in der Kondensatorbatterie kein Fehler vor, so sind die Differenzströme Null bzw. liegen unterhalb eines vorgegebenen Wertes oder werden in einer der Auswerteschaltungen stationär kompensiert.

Wird bei einem von der linken Kondensatorseite a₁, a₂, a₃ zur rechten Kondensatorseite b₁, b₂, b₃ fließenden Strom eine positive Phasenlage und umgekehrt eine negative Phasenlage beim Fließen der Ströme von b nach a angenommen, so ergibt sich je nach der Phasenlage der einzelnen Querströme eine Fehlerzuordnung zu einem Teil der Kondensatorbatterie; ist z.B. der Querstrom Δ i₁₂ positiv und der Querstrom Δ i₂₃ negativ, so muß der Fehler in der Teilbatterie a₂ liegen (vgl. FIG 3).

Aus Kostengründen kann es vorteilhaft sein, wenn die beiden Querzweige - elektrisch gesehen - auf nahezu gleichem Potential liegen, d.h. nur wenige Bausteine im mittleren Teil mₐ und m_{b} in Reihe geschaltet sind. Dies hat den Vorteil, daß man mit einem Wandler WA auskommt, der zwei getrennte Wicklungen S₁, S₂ hat. Hierdurch kann man an Einbauplatz sparen (vgl. FIG 4).

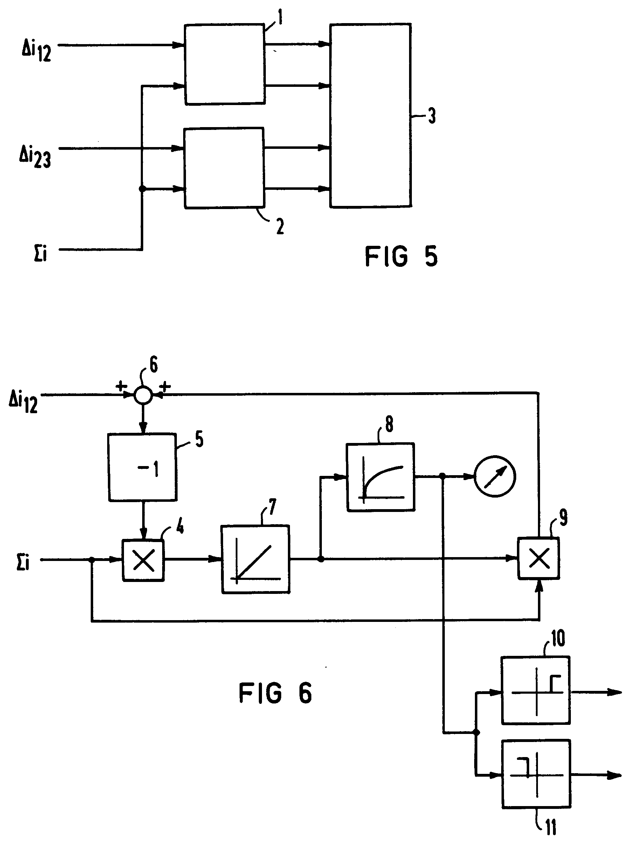

Wie die in FIG 5 gezeigte Auswerteschaltung erkennen läßt, werden in Vorzeichenbausteinen 1 und 2 die Phasenlage + oder - der Querströme Δ i₁₂ usw. zum Gesamtstrom Σi bestimmt. Aus den logischen Ausgangssignalen dieser Vorzeichenbausteine 1 und 2 wird mittels einer Auswähllogik 3 ermittelt, in welchem Teil der Kondensatorbatterie der Fehler liegen muß. Ist der Fehler ermittelt, so wird die Schaltungsanordnung automatisch neu justiert, und zwar durch den Integrator 7 (FIG 6), d.h. der Fehler wird elektrisch ausgeglichen und damit die Anlage für eine erneute Fehlererkennung scharfgemacht.

Wie FIG 6 erkennen läßt, besteht jeder Vorzeichenbaustein im wesentlichen aus zwei Multipliziergliedern 4 und 9 mit einem Integrator 7. Das Summensignal wird hierbei einem Multipliezierer 4 zugeführt und gelangt von hier aus über den Integrator 7 an den Multiplizierer 9, dem ebenfalls das Summensignal Σi zugeführt wird. Das Ausgangssignal des Multipliziergliedes 9 wird an einer Summierstelle 6 mit dem Querstrom, z.B. Δ i₁₂ addiert und über einen Umkehrverstärker 5 als weitere Eingangsgröße dem Multiplizierer 4 aufgeschaltet. Damit ergibt sich am Ausgang des Integrators 7 ein vorzeichenbehaftetes Signal Plus bzw. Minus, das ein Maß für die Phasenlage des Stromes Δ i₁₂ zum Summenstrom Σi ist. Diese Schaltung ist in näheren Einzelheiten in der deutschen Patentanmeldung DE-OS 29 30 034 beschrieben. Das so gewonnene Signal wird über ein Verzögerungsglied 8 zur Unterdrückung von transienten Störungen zwei Auswertestufen 10 und 11 zugeführt, an deren Ausgang ein Plus- bzw. Minussignal ± abgegeben wird, welches dann in der Logik 3 weiterverarbeitet wird.

## Patentansprüche

1. Verfahren zur Erfassung eines inneren Fehlers und gleichzeitiger Zuordnung dieses Fehlers zum jeweils fehlerbehafteten Kondensatorbaustein (a₁,a₂,a₃,b₁,b₂,b₃) einer aus zumindest zwei parallelen Zweigen mit jeweils mindestens drei in Reihe geschalteten Kondensatorbausteinen (a₁, a₂,b₁,b₂) bestehenden Hochspannungskondensatorbatterie, wobei jeweils zwischen zwei Parallelzweigen jeweils die fließenden Querströme (Δi₁₂,Δi₂₃) in ihren Phasenlagen zu einem gemessenen Gesamtstrom (Σi) der Hochspannungskondensatorbatterie erfaßt werden und in Abhängigkeit jeweils der Phasenvergleiche der Querströme (Δi₁₂ bzw. Δi₂₃) und des Gesamtstromes (Σi) ein auftretender Fehler einem Kondensatorbaustein (a₁...,a₃, b₁...,b₃) zuordenbar ist.

2. Vorrichtung zur Durchführung des Verfahrens nach Anspruch 1 bei einer aus zumindest zwei parallelen Zweigen mit jeweils mindestens drei in Reihe geschalteten Kondensatorbausteinen (a₁,a₂,b₁,b₂) bestehenden Hochspannungskondsatorbatterie, wobei die Vorrichtung aus mindestens einem Querstromwandler (WA) und einer aus mindestens zwei Vorzeichenbausteinen (1 bzw. 2) mit nachgeschalteter Auswähllogik (3) bestehenden Auswerteschaltung besteht, wobei jeweils dem Vorzeichenbaustein (1 bzw. 2) ein ermittelter Querstrom (Δi₁₂ bzw. Δi₂₃) und der ermittelte Gesamtstrom (Σi) zugeführt sind.

3. Vorrichtung nach Anspruch 2, **dadurch gekennzeichnet,** daß ein Querstromwandler (WA) mit mehreren Sekundärwicklungen (S₁,S₂) vorgesehen ist.

4. Vorrichtung nach Anspruch 2, **dadurch gekennzeichnet,** daß ein Vorzeichenbaustein (1 bzw. 2) aus zwei Multiplizierglieder (4,9), einem Integrator (7), einem Umkehrverstärker (5) und einer Summierstelle (6) besteht, wobei der Ausgang des ersten Multipliziergliedes (4) über dem Integrator (7) mit einem ersten Eingang des zweiten Multipliziergliedes (9) verknüpft ist, dessen Ausgang mit einem Eingang der Summierstelle (6) verbunden ist, wobei der Ausgang dieser Summierstelle (6) über einen Umkehrverstärker (5) mit einem ersten Eingang des ersten Multipliziergliedes (4) verbunden ist, wobei an den zweiten Eingängen der Multiplizierglieder (4,9) der Gesamtstrom (Σi) und am zweiten Eingang der Summierstelle (6) ein Querstrom (Δi₁₂ bzw. Δi₂₃) anstehen und wobei am Ausgang des Integrators (7) ein vorzeichenbehaftetes Signal ansteht.

5. Vorrichtung nach Anspruch 4, **dadurch gekennzeichnet,** daß der Integrator (7) ausgangsseitig außerdem mittels eines Verzögerungsgliedes (8) mit zwei Auswertestufen (10,11) verknüpft ist.

## Claims

1. A method for detecting an internal fault and simultaneous allocation of this fault to the respective faulty capacitor modules (a₁,a₂,a₃,b₁,b₂,b₃) of a high-voltage capacitor battery consisting of at least two parallel branches with in each case at least three capacitor modules (a₁, a₂,b₁,b₂) connected in series, wherein in each case the respective shunt currents (Δi₁₂,Δi₂₃) flowing between two parallel branches are detected in their phase angles relative to a measured total current (Σi) of the high-voltage capacitor battery and, in dependence in each case on the phase comparisons of the shunt currents (Δi₁₂ or Δi₂₃) and of the total current (Σi), a fault which occurs is able to be allocated to a capacitor module (a₁...,a₃, b₁...,b₃).

2. A device for carrying out the method according to claim 1 in a high-voltage capacitor battery consisting of at least two parallel branches with in each case at least three capacitor modules (a₁,a₂,b₁,b₂) connected in series, wherein the device consists of at least one shunt current transformer (WA) and an evaluating circuit consisting of two sign modules (1 or 2) with a selection logic system (3) connected thereafter, wherein in each case a determined shunt current (Δi₁₂ or Δi₂₃) and the determined total current (Σi) are supplied to the sign module (1 or 2).

3. A device according to claim 2, characterised in that a shunt current transformer (WA) is provided with several secondary windings (S₁,S₂).

4. A device according to claim 2, characterised in that a sign module (1 or 2) consists of two multiplier elements (4,9), an integrator (7), an inverting amplifier (5) and a summing point (6), wherein the output of the first multiplier element (4) is linked via the integrator (7) with a first input of the second multiplier element (9), the output of which is connected to an input of the summing point (6), wherein the output of this summing point (6) is connected by way of an inverting amplifier (5) with a first input of the first multiplier element (4), wherein the total current (Σi) is applied at the second inputs of the multiplier elements (4,9) and a shunt current (Δi₁₂ or Δi₂₃) at the second input of the summing point (6) and wherein a signal with a sign is applied at the output of the integrator (7).

5. A device according to claim 4, characterised in that the integrator (7) is linked on the output side moreover by means of a delay element (8) with two evaluating stages (10,11).

## Revendications

1. Procédé pour la détection d'un défaut interne et l'association simultanée de ce défaut au module de condensateur défectueux (a₁, a₂, a₃, b₁, b₂, b₃) d'une batterie de condensateurs à haute tension, constituée respectivement par au moins trois modules de condensateurs (a₁, a₂, b₁, b₂) branchés en série, et selon lequel les positions de phase respectives des courants transversaux circulants respectifs (Δi₁₂, Δi₂₃) par rapport à un courant total mesuré (Σi) de la batterie de condensateurs à haute tension, sont détectées respectivement entre deux branches parallèles, et un défaut apparu peut être associé à un module de condensateur (a₁..., a₃, b₁..., b₃) en fonction des comparaisons respectives de phase des courants transversaux (Δi₁₂ ou Δi₂₃) et du courant total (Σi).

2. Dispositif pour la mise en oeuvre du procédé suivant la revendication 1, dans lequel l'une des au moins deux branches parallèles comportant une batterie de condensateurs à haute tension constituée par au moins trois modules de condensateurs (a₁, a₂, b₁, b₂) branchés en série, ce dispositif étant constitué par au moins un transformateur d'intensité transversal (WA) et par un circuit d'évaluation constitué par au moins deux modules (1 ou 2) produisant un signe et en aval desquels est branchée une logique de sélection (3), un courant transversal déterminé (Δi₁₂ ou Δi₂₃) et le courant total déterminé (ΣI) étant envoyés respectivement au module (1 ou 2) qui délivre un signe.

3. Dispositif suivant la revendication 2, caractérisé par le fait qu'il est prévu un transformateur (WA) d'intensité du courant transversal, qui comporte plusieurs enroulements secondaires (S₁, S₂).

4. Dispositif suivant la revendication 2, caractérisé par le fait qu'un module (1 ou 2) délivrant un signe est constitué par deux circuits multiplicateurs (4,9), un intégrateur (7), un amplificateur inverseur (5) et un noeud d'addition (6), la sortie du premier circuit multiplicateur (4) étant raccordée par l'intermédiaire de l'intégrateur (7) à une première entrée du second circuit multiplicateur (9), dont la sortie est connectée à une entrée du noeud d'addition (6), dont la sortie est connectée par l'intermédiaire d'un amplificateur inverseur (5) à une première entrée du premier circuit multiplicateur (4), tandis que le courant total (Σi) est appliqué aux secondes entrées des circuits multiplicateurs (4,9) et qu'un courant transversal (Δi₁₂ ou Δi₂₃) est appliqué à la seconde entrée du noeud d'addition (6) et qu'un signal affecté d'un signe est présent à la sortie de l'intégrateur (7).

5. Dispositif suivant la revendication 4, caractérisé par le fait que l'intégrateur (7) est en outre connecté, côté sortie, au moyen d'un circuit de retardement (8), à deux étages d'évaluation (10,11).
